# EUROPEAN PATENT APPLICATION

(11) **EP 4 764 471 A1**
(43) Date of publication of application: **24.06.2026**
(21) Application number: 24865271.1
(22) Date of filing: 30.08.2024
(51) Int. Cl.: G01N 21/956, H01L 21/66

(54) **METHOD FOR EVALUATING SUBSTRATE AND DEVICE FOR EVALUATING SUBSTRATE**

(30) Priority: 14.09.2023 JP 2023149657
(71) Applicant: Kwansei Gakuin Educational Foundation, Nishinomiya-shi, Hyogo 662-8501 (JP); YGK Corporation, Alps-shi, Yamanashi 400-0311 (JP); Toyota Tsusho Corporation, Nagoya-shi Aichi 450-8575 (JP)
(72) Inventor: KANEKO, Tadaaki, Sanda-shi, Hyogo 669-1330 (JP); DOJIMA, Daichi, Sanda-shi, Hyogo 669-1330 (JP); Asakawa, Kazunobu, Alps-shi, Yamanashi 400-0311 (JP); Nakura, Yoshinobu, Alps-shi, Yamanashi 400-0311 (JP)
(74) Representative: Schön, Christoph
(86) International application number: PCT/JP2024/031150
(87) International publication number: WO 2025/057769

(57) **Abstract**

Provided is a technique for more suitably inspecting an anisotropic object in a substrate by using a laser light scattering method. For each measurement region on a substrate surface, scattered light is measured using an optical system in a first direction and a second direction with reference to the measurement region to obtain first measurement data and second measurement data, and the first measurement data and the second measurement data are combined to generate composite data.

## Description

### Technical Field

The present invention relates to a substrate evaluation method using laser light scattering and an evaluation device

### Background Art

In a substrate such as a semiconductor, foreign matters may adhere to a surface or defects may occur on the surface or inside in a manufacturing or processing process. Since foreign matters and defects on the substrate may lead to the generation of defective products, a technology for evaluating the substrate is indispensable. For example, in a semiconductor device manufactured using a semiconductor substrate, the presence of foreign matters and defects leads to degradation in device performance or device malfunction.

In substrate inspection using the laser light scattering, the surface of the substrate is irradiated with a laser beam, the scattered light is measured, and thus the state of the surface or the inside of the substrate can be inspected. In the entire surface inspection of the substrate, a method for scanning a two-dimensional surface of the substrate with a laser beam and measuring scattered light generated in each region of the substrate is generally used.

In the substrate inspection using the laser light scattering, the anisotropy of the inspection target affects the measurement data. In order to inspect all the inspection targets that are difficult to detect due to the anisotropy of the inspection target without omission, Patent Literature 1 describes the following surface state inspection device.

Patent Literature 1 discloses a surface state inspection device for a flat substrate, which scans a surface of the flat substrate placed on an X-axis Y-axis stage with a laser beam emitted by a light projection system in either an X-axis direction or a Y-axis direction by the X-axis Y-axis stage, receives scattered light from the surface by a light reception system while the laser beam is fed in an axial direction orthogonal to the scanning direction at predetermined intervals, and inspects an entire surface state of the flat substrate using a detection signal in accordance with received light intensity, the surface state inspection device including: at least two light projection systems that are provided on a surface side of the flat substrate and irradiate the surface with the laser beam from different directions at a predetermined incident angle with respect to a substrate normal of the flat substrate; at least two light reception systems that are provided on the surface side and face the light projection systems at a position opposite to the projection systems with an irradiation point of the laser beam as a reference; a laser beam shaping means for shaping the laser beam such that the laser beam irradiation region, where each laser beam is emitted onto the surface of the flat substrate, becomes rectangular; an irradiation region spacing adjustment means for adjusting each light projection system and each light reception system such that the spacing between the rectangularly shaped laser beam irradiation regions is set to a projection length of the rectangle in the scanning direction or a non-overlapping length, the non-overlapping length being a length where the laser beam irradiation regions do not overlap; and a feed interval adjustment means for adjusting a predetermined interval for feeding in the axial direction to be equal to or greater than the projection length or the non-overlapping length, or to an integer multiple of the projection length or the non-overlapping length.

### Citation List

### Patent Literature

Patent Literature 1: JP 2015-075339 A

### Summary of Invention

### Technical Problem

As a result of further studies on the above-described technology, the inventors have invented a method for improving the influence on measurement due to the anisotropy of the substrate and enabling more appropriate evaluation in the substrate evaluation using the laser light scattering. An object of the present invention is to provide a technology for more suitably inspecting an anisotropic target on a substrate using laser light scattering.

### Solution to Problem

[1] A substrate evaluation method using laser light scattering, the method comprising:
   a measurement step of measuring scattered light for each measurement region on a substrate surface using optical systems present in a first direction and a second direction with reference to the measurement region to obtain first measurement data and second measurement data; and
   a synthesis step of synthesizing the first measurement data and the second measurement data to generate synthetic data.
[2] The substrate evaluation method according to [1], in which the first direction and the second direction are different in an in-plane direction of the substrate.
[3] The substrate evaluation method according to [1] or [2], in which the first direction and the second direction are orthogonal to each other in an in-plane direction.
[4] The substrate evaluation method according to any one of [1] to [3], in which each of the optical systems includes a light reception optical system that receives scattered light generated on the substrate, and
   in the measurement step, the scattered light is measured using the light reception optical systems present in the first direction and the second direction with reference to the measurement region to obtain the first measurement data and the second measurement data.
[5] The substrate evaluation method according to any one of [1] to [3], in which each of the optical systems includes a light projection optical system that irradiates a surface of the substrate with a laser beam, and
   in the measurement step, the scattered light generated using the light projection optical systems present in the first direction and the second direction with reference to the measurement region is measured to obtain the first measurement data and the second measurement data.
[6] The substrate evaluation method according to any one of [1] to [5], in which the measurement step includes measuring the scattered light in each of a plurality of the measurement regions on the substrate by scanning the substrate surface with a laser beam.
[7] The substrate evaluation method according to [6], in which the first direction and the second direction are set with respect to the scanning direction.
[8] The substrate evaluation method according to [6] or [7], in which the longitudinal direction of the measurement region is set so as to be inclined with respect to the scanning direction.
[9] The substrate evaluation method according to any one of [1] to [8], in which the measurement step includes measuring the scattered light by irradiating a surface of the substrate with a laser beam while rotating the substrate in an in-plane direction.
[10] The substrate evaluation method according to [9], in which in the measurement step, the substrate is rotated in the in-plane direction to irradiate a rotational trajectory of the substrate with the laser beam, and
   the in-plane direction of the first direction and the in-plane direction of the second direction are set at a first angle and a second angle with respect to the rotational trajectory.
[11] The substrate evaluation method according to any one of [1] to [10], in which the measurement step includes a first measurement step and a second measurement step,
   in the first measurement step and the second measurement step, the first measurement data and the second measurement data are acquired by measuring the scattered light while changing an orientation of the measurement region with respect to the optical systems whose positions are fixed, and
   in the synthesis step, positional information of the first measurement data and positional information of the second measurement data are aligned to generate the synthetic data.
[12] The substrate evaluation method according to [11], in which in the first measurement step, the first measurement data is obtained by scanning a laser beam by moving the substrate in a first movement direction while rotating the substrate in an in-plane direction, and
   in the second measurement step, the second measurement data is obtained by scanning the laser beam by moving the substrate in a second movement direction different from the first movement direction while rotating the substrate in the in-plane direction.
[13] The substrate evaluation method according to [11] or [12], in which in the second measurement step, measurement is started in a state in which the substrate is rotated by 90 degrees or 270 degrees from the start of measurement in the first measurement step.
[14] The substrate evaluation method according to any one of [11] to [14], in which the scattered light is measured using a same optical system in the first measurement step and the second measurement step.
[15] The substrate evaluation method according to any one of [1] to [14], in which the measurement region has a linear shape or a rectangular shape.
[16] A substrate evaluation device using laser light scattering, the device comprising:
   a light projection optical system that irradiates a substrate with a laser beam;
   a light reception optical system that measures scattered light;
   a stage that includes a three-axis drive unit that moves the substrate in a plane; and
   a control unit that controls movement of the stage to a reference position of the substrate, the position being a start position of each of first measurement and second measurement.
[17] The substrate evaluation device according to [16], in which the stage further includes a rotation drive unit that rotates the substrate, and
   the control unit controls planar movement of the stage in different feed directions in the first measurement and the second measurement using the three-axis drive unit while rotating the stage using the rotation drive unit.
[18] The substrate evaluation device according to [16] or [17], in which the control unit aligns positions for two pieces of measurement data measured by moving the stage in the first movement direction and the second movement direction, and performs synthesis processing to synthetic data.

In the invention according to [1], it is possible to generate the synthetic data of the measurement data in two directions on the substrate and accurately evaluate the substrate including an anisotropic inspection target.

In the invention according to [2], it is possible to accurately evaluate the substrate including an anisotropic inspection object in the in-plane direction.

In the invention according to [3], it is possible to obtain measurement data with the maximum amount of information in two directions.

In the invention according to [4], by receiving the scattered light in two directions, it is possible to accurately evaluate the substrate including the anisotropic inspection object.

In the invention according to [5], by generating scattered light in two directions and measuring the scattered light, it is possible to accurately evaluate the substrate including the anisotropic inspection object.

In the invention according to [6], by scanning a laser beam, it is possible to measure the scattered light of each of a plurality of measurement regions and evaluate the scattered light on the entire surface of the substrate.

In the invention according to [7], by setting two directions with respect to the scanning direction and performing scanning, it is possible to obtain measurement data obtained in the two directions on the entire surface of the substrate.

In the invention according to [8], by widening the width of the measurement region and performing scanning, it is possible to shorten the scanning time.

In the invention according to [9], it is possible to measure the scattered light at high speed on the entire surface of the substrate by irradiation with the laser beam due to rotation.

In the invention according to [10], by setting and measuring two angles with respect to the rotational trajectory, it is possible to obtain measurement data obtained in two directions on the entire surface of the substrate.

In the invention according to [11], it is possible to obtain measurement data using one optical system by changing the orientation of the measurement region in two measurement steps.

In the invention according to [12], it is possible to obtain measurement data in two directions through the operation of rotating and moving the substrate.

In the invention according to [13], by rotating the substrate at the start of the measurement, it is possible to start the measurement in a state in which the substrate position is aligned.

In the invention according to [14], it is possible to suppress a difference in measurement data resulting from an individual difference of an optical system.

In the invention according to [15], by widening the width of the measurement region and performing the measurement, it is possible to perform the measurement in a short time.

In the invention according to [16], it is possible to implement stage control to a position suitable for position alignment when measuring two different pieces of measurement data.

In the invention according to [17], by moving the stage in different feed directions in the rotational scanning, it is possible to obtain a result of measuring the scattered light in different directions with respect to a certain region of the substrate.

In the invention according to [18], by aligning positions of two different pieces of measurement data, it is possible to generate synthetic data for evaluating the substrate including the anisotropic inspection object.

### Advantageous Effects of Invention

According to the present invention, it is possible to provide a technology for more suitably inspecting an anisotropic target on a substrate using laser light scattering.

### Brief Description of Drawings

Fig. 1 is a schematic explanatory diagram of a substrate evaluation method.
Fig. 2 is a configuration diagram of an evaluation device.
Fig. 3 is a schematic explanatory diagram of a measurement region according to an embodiment.
Fig. 4 is a schematic explanatory diagram of a measurement region according to the embodiment.
Fig. 5 is a schematic explanatory diagram of a measurement step according to a first example.
Fig. 6 is a schematic explanatory diagram of a measurement step according to a second example.
Fig. 7 is a schematic explanatory diagram of a measurement step according to a third example.
Fig. 8 is a diagram illustrating an orientation that is measured as strong scattered light in each measurement step.
Fig. 9 is an explanatory diagram of a measurement step at the time of scanning.
Fig. 10 is an explanatory diagram of position alignment processing.
Fig. 11 is an example of measurement data.
Fig. 12 is an example of synthetic data.

### Description of Embodiments

Preferred embodiments of a substrate evaluation method and a substrate evaluation device according to the present invention will be described in detail with reference to the following accompanying drawings. The technical scope of the present invention is not limited to the embodiments illustrated in the accompanying drawings, and can be appropriately changed within the scope described in the claims. Note that in the following description of the embodiment and the accompanying drawings, the same reference numerals are given to the same components, and redundant description will be omitted.

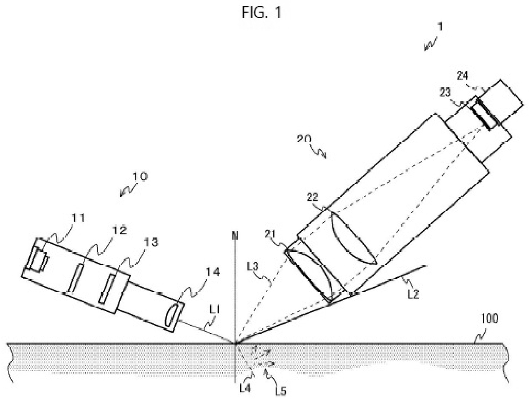

Fig. 1 is a schematic explanatory diagram of a substrate evaluation method of the present invention. As illustrated in Fig. 1, an evaluation device 1 includes a light projection optical system 10 and a light reception optical system 20.

The light projection optical system 10 includes a laser output unit 11, a filter 12, a wave plate 13, and a condenser lens 14.

The light reception optical system 20 includes an objective lens 21, a imaging lens 22, a slit 23, and a light reception sensor 24. The light reception sensor 24 converts the intensity of the scattered light into an electrical signal and uses the electrical signal as measurement data.

A substrate 100 may be a semiconductor wafer, a mask, a disk substrate, a liquid crystal substrate, a glass substrate, a transparent film, or the like. In the present embodiment, an example in which the substrate 100 is particularly a semiconductor single crystal will be described.

The substrate 100 includes, as inspection targets, surface inspection targets such as a foreign matter (such as fine dust or the like) adhering to the surface, scratches/cracks, and surface unevenness, and internal inspection targets such as crystal defects and subsurface damaged layers, which are generated internally. The inspection target is irradiated with a laser beam to generate scattered light. Therefore, the evaluation device 1 can inspect the presence or absence and the degree of the inspection target included on the substrate 100 by measuring the scattered light.

As an example, the substrate 100 is a semiconductor material manufactured by a process including at least one of a slicing step, a polishing step, or a grinding step. Examples of the semiconductor substrate manufactured through these steps include a silicon (Si) substrate. In the slicing step, the polishing step, and the grinding step described above, a subsurface damaged layer that adversely affects device manufacturing may be introduced. In particular, recent studies have revealed that the subsurface damaged layer adversely affects the device in a compound semiconductor material classified as a material that is difficult to process.

As the semiconductor single crystal, a material such as silicon or a compound semiconductor can be adopted. The compound semiconductor includes SiC, GaN, AlN, Ga₂O₃, and sapphire. In the present embodiment, the substrate 100 will be described by using single crystal SiC as an example, but is not limited thereto.

The subsurface damaged layer includes crystal lattice strain generated internally due to the processing of the substrate. The strain that adversely affects semiconductor device manufacturing is located in a depth range of 1 µm to 20 µm, 1 µm to 10 µm, 1 µm to 8 µm, 1 µm to 6 µm below the surface of the semiconductor substrate. The inspection area in the depth direction of the evaluation device 1 is in at least one of depth ranges up to 20 µm, 10 µm, 8 µm, or 6 µm below the surface of the semiconductor substrate.

The strain refers to a deviation of an actual crystal lattice from a reference in a case where an ideal crystal lattice is used as a reference. Furthermore, the strain amount is a value indicating the degree of the strain. The evaluation method of the present invention includes evaluating the amount of strain of a substrate as the target, its distribution, or its uniformity.

The light projection optical system 10 irradiates the surface of the substrate 100 with the incident light L1. The incident light L1 is divided into the reflected light L2, the surface scattered light L3, and the transmitted light L4 at the surface of the substrate 100. In the present embodiment, it is preferable that the reflected light L2 travels along a path that does not enter the light reception optical system 20. The surface scattered light L3 can travel along a path that enters the light reception optical system 20. The transmitted light L4 enters the inside of the substrate 100, and can travel along a path that enters the light reception optical system 20 as the internal scattered light L5.

The light reception optical system 20 focuses the surface scattered light L3 and the internal scattered light L5 onto the light reception sensor 24 by the objective lens 21 and the imaging lens 22. The slit 23 selectively blocks the surface scattered light L3 and the internal scattered light L5 to be focused onto the light reception sensor 24. For example, the slit 23 can be disposed to selectively block only the surface scattered light L3, only the internal scattered light L5, or the surface scattered light L3 and the internal scattered light L5. Furthermore, the slit 23 can be disposed to selectively block the internal scattered light L5 generated at an arbitrary depth from the surface of the substrate 100 with respect to the internal scattered light L5. As the slit 23, a variable slit that allows selection of the range of scattered light to be blocked may be adopted.

The scattered light may include surface scattered light and the internal scattered light. The surface scattered light may include scattered light derived from surface adherent matters, scattered light derived from surface irregularities, and scattered light derived from lattice defects. The internal scattered light may include scattered light derived from lattice defects and scattered light derived from internal strain.

Here, in particular, in a case where internal scattered light L5 derived from internal strain is measured, it is preferable that the generation and/or the detection of scattered light that is not the detection target, including scattered light derived from surface adherent matters, scattered light derived from surface irregularities, and scattered light derived from lattice defects other than the scattered light derived from internal strain, is suppressed by an appropriate method. However, the scattered light may include scattered light that is not the detection target within a range in which the intensity of the scattered light derived from internal strain can be determined.

In a case where the internal scattered light L5 derived from internal strain is measured, the surface scattered light L3 is less likely to occur or the intensity of the surface scattered light L3 is reduced by forming the surface of the substrate 100 as a planarized surface through planarization processing. Thus, in the scattered light, the proportion of scattered light generated in the subsurface damaged layer beneath the surface increases.

The surface of the substrate 100, which is formed of a semiconductor material, is planarized by planarization processing such as chemical mechanical polishing. Quantitatively, the surface includes a surface having an arithmetic mean roughness (Ra) of 0.5 nm or less. Preferably, the surface includes a surface having an arithmetic mean roughness (Ra) of 0.4 nm or less, 0.3 nm or less, or 0.2 nm or less.

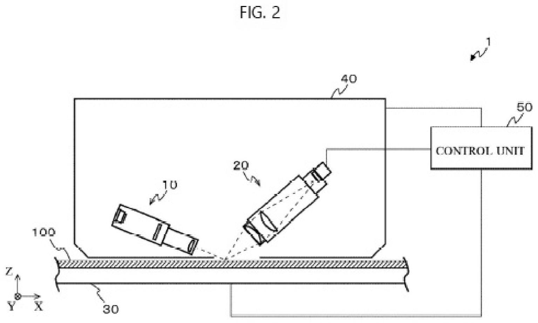

Fig. 2 illustrates an example of a configuration diagram of the evaluation device 1. The evaluation device 1 includes a light projection optical system 10, a light reception optical system 20, a stage 30, a housing 40, and a control unit 50.

The light projection optical system 10 irradiates the substrate 100 with a laser beam having a transmissive wavelength.

An incident angle θ of the laser beam emitted by the light projection optical system 10 can be set to 0° ≤ θ < 90°. The incident angle θ of the laser beam is not limited to vertical irradiation where 0° = θ.

The incident angle θ of the laser beam preferably satisfies 40° ≤ θ, 45° ≤ θ, or 50° ≤ θ at its lower limit, and θ ≤ 80°, θ ≤ 75°, or θ ≤ 70° at its upper limit.

In a case where the incident angle θ is near the Brewster's angle of the substrate 100 (Brewster's angle ± about 10°), the P-polarized light penetrates deeper into the substrate 100, and an inspection target in a deep portion beneath the surface can be detected.

The light projection optical system 10 can vary an incident angle with respect to the substrate 100. The incident angle of the light projection optical system 10 is adjusted in accordance with an angle control instruction from the control unit 50. When a measurement region 101 is irradiated with the laser beam at different incident angles, the laser beam irradiation direction with respect to the inspection target changes, and thus scattered light of different patterns is generated. As one aspect, in the measurement step, the intensity of the scattered light can be measured at a certain incident angle, and further, the intensity of the scattered light can be measured by changing the incident angle.

The laser output unit 11 is a laser beam generation source, and for example, a gas laser such as a He-Ne laser, a semiconductor laser, a solid laser such as a YAG laser, or the like can be adopted. Note that the fundamental wavelength of the laser beam output by the laser output unit 11 is converted, and wavelengths of the second harmonic and the third harmonic can be adopted.

In the present embodiment, in a case where the substrate 100 is formed of a semiconductor material, the wavelength of the laser beam desirably has photon energy greater than the bandgap. That is, the wavelength λ of the laser beam desirably satisfies a relational expression of "λ [nm] ≤ 1239.8/bandgap [eV]".

Specifically, in a case where the measurement target is 4H-SiC, it is desirable to set the wavelength to 380 nm or less (λ [nm] ≤ 1239.8/3.26 [eV]). In a case where the measurement target is formed of GaN, the wavelength is desirably set to 365 nm or less (A [nm] ≤ 1239.8/3.39 [eV]).

The filter 12 is configured as a wavelength filter that transmits a laser beam of a specific wavelength or a wavelength filter that blocks a laser beam of a specific wavelength. As the filter 12, a wavelength filter corresponding to the wavelength of the laser beam to be used can be adopted. The laser beam passes through the filter 12 to have a single wavelength. The laser beam having a wide spectral width excites photoluminescence inside the substrate 100, which causes measurement noise. Furthermore, in a case where the fundamental wavelength is converted into the second harmonic, the third harmonic, or the like and used, other wavelengths that are not used for measurement may cause noise. In the present embodiment, the laser beam preferably has a single wavelength by using the filter 12.

The wave plate 13 includes a rotation mechanism, and can polarize the polarization direction of the transmitted laser beam to P-polarized light or S-polarized light. The wave plate 13 can set the laser beam as an arbitrary polarized beam in accordance with the polarization instruction from the control unit 50. Since the P-polarized and S-polarized laser beams have different transmittances with respect to the substrate 100, the wave plate 13 is controlled in accordance with the depth of the inspection target. The polarization state of the wave plate 13 is controlled in accordance with a polarization control instruction from the control unit 50.

The condenser lens 14 is a lens that spots the laser beam onto the surface of the substrate 100. The condenser lens 14 may be configured to shape a laser beam into an arbitrary beam shape such as a circular shape, an elliptical shape, a rectangular shape, and a linear shape. In the present embodiment, the condenser lens 14 is a cylindrical lens. The cylindrical lens spots parallel light in a rectangular shape or a linear shape. By inclining the longitudinal direction of the rectangular or linear spot with respect to the scanning direction, the wide area can be measured with a single scan, and highspeed measurement is implemented.

The light reception optical system 20 measures the intensity of scattered light generated by the substrate 100. The light reception optical system 20 is preferably disposed at an angle that does not allow the reflected light on the surface of the substrate 100 to enter.

The measurement angle φ of the light reception optical system 20 can be set to 0° ≤ θ <90°, and the installation upward is not limited with 0° = φ. The measurement angle φ of the light reception optical system 20 preferably satisfies 20° ≤ φ, 25° ≤ φ, or 30° ≤ φ as a lower limit, and φ ≤ 70°, φ ≤ 65°, or φ ≤ 60° as an upper limit. The preferable measurement angle φ can suppress the entrance of scattered light at a depth close to the surface of the substrate 100.

The light reception sensor 24 converts the scattered light, which passes through the slit 23 and is imaged, into an electrical signal in accordance with its intensity. As the light reception sensor 24, a photomultiplier tube, a photodiode, or the like can be adopted. The light reception sensor 24 can adjust light reception sensitivity. For example, when weak scattered light such as scattered light derived from internal strain is targeted, the light reception sensor 24 can set the light reception sensitivity to be high.

The light reception optical system 20 preferably further includes a wavelength filter. The wavelength filter is disposed for the purpose of blocking light of a wavelength other than a wavelength in accordance with the wavelength of the laser beam output from the light projection optical system 10. For example, the wavelength filter blocks a wavelength that may be noise in intensity measurement of scattered light, such as photoluminescence generated in the substrate 100.

The substrate 100 is disposed on the stage 30. The stage 30 includes a three-axis drive unit 31 and a rotation drive unit 32. The stage 30 can move in an XY direction which is a two-dimensional plane. Furthermore, the stage 30 can rotate in a two-dimensional plane. The stage 30 can scan the substrate 100 with the laser beam by moving and/or rotating in a two-dimensional plane.

The stage 30 can move in the horizontal direction and the vertical direction by driving the three-axis drive unit 31 in accordance with a movement instruction from the control unit 50. The stage 30 can be rotated by driving the rotation drive unit 32 in accordance with a rotation instruction from the control unit 50.

The stage 30 is controlled to move and/or rotate based on the stage position information. The stage position information includes an orthogonal coordinate system (X, Y, Z) and a rotational coordinate system (r, θ). The rotational coordinate system is represented by a feed position r in the radial direction of the substrate 100 due to the feed movement and a rotation angle θ. The direction of the feed movement corresponds to the directions of the X-axis and the Y-axis of the orthogonal coordinate system, and is controlled by driving of the three-axis drive unit 31. In the rotational coordinate system, the substrate 100 at the feed position r is moved in the X-axis or the Y-axis while being rotated in the θ direction, and thus the substrate 100 is effectively moved in the r direction. The feed position r in the feed movement in the rotational coordinate system and the orthogonal coordinate position XY in the horizontal movement in the orthogonal coordinate system are distinguished as positional information.

Note that the stage 30 may be configured to be controlled in the movement and/or rotation based on the substrate position information. The substrate position information has an orthogonal coordinate system (X, Y, Z) and/or a rotational coordinate system (r, θ). The substrate position information is information indicating a position on the substrate 100. In the evaluation of the substrate 100 according to the present embodiment, the distribution of the inspection object included in the substrate 100 can be evaluated from the measurement result of the scattered light intensity at each position on the substrate 100 indicated by the substrate position information.

The housing 40 supports the light projection optical system 10 and the light reception optical system 20. Note that the housing 40 may be movable in the horizontal direction and the vertical direction. The housing 40 can be configured to perform scanning of the laser beam by movement in accordance with a movement instruction from the control unit 50.

In the present embodiment, the stage 30 moves in the Z-axis which is the vertical direction when aligning the spot of the irradiation light with the substrate 100. Note that the housing 40 may be configured to move in the vertical direction when aligning the spot of the irradiation light with the surface of the substrate 100.

The control unit 50 is connected to the stage 30 and controls the movement and rotational drive of the stage 30. The control unit 50 acquires measurement data obtained by the light reception optical system 20. The control unit 50 executes synthesis processing of the measurement data.

The control unit 50 includes a stage control unit 51 that controls the stage 30, a signal processing unit 52 that performs signal processing as measurement data (measurement result) based on the intensity of the scattered light received by the light reception sensor 24, and a synthesis processing unit 53 that performs synthesis processing for obtaining synthetic data based on at least two or more pieces of measurement data.

The control unit 50 controls a measurement mode in accordance with the inspection target. The measurement mode can include modes respectively corresponding to a depth, a type, and the like of the inspection target. The measurement mode includes a surface measurement mode corresponding to the depth of the inspection target and an internal measurement mode. The surface measurement mode is a mode for measuring surface inspection targets such as particles. The internal measurement mode is a mode for measuring an internal inspection target such as a subsurface damaged layer. The control unit 50 can output a control instruction for S-polarized light to the wave plate 13 in the surface measurement mode, and can output a control instruction for P-polarized light to the wave plate 13 in the internal measurement mode. Furthermore, in the internal measurement mode, the control unit 50 outputs, to the wave plate 13, a control instruction to selectively switch the S-polarized light or the P-polarized light in accordance with the target depth. For example, in a case where the internal strain of the subsurface damaged layer is targeted in the internal measurement mode, the control unit 50 outputs a control instruction for S-polarized light to the wave plate 13.

The control unit 50 includes one or more processors such as a central processing unit (CPU). The control unit 50 executes various processing as the stage control unit 51, the signal processing unit 52, and the synthesis processing unit 53 by executing a program stored in the storage device. The control unit 50 can receive an input operation via the operation interface of the evaluation device 1 and execute a measurement step and a synthesis step in accordance with the input operation.

The evaluation method according to the present embodiment includes a measurement step and a synthesis step. The measurement step is a step of irradiating the substrate 100 with a laser beam and measuring the intensity of scattered light by the irradiation. In the present embodiment, the measurement step includes a first measurement step and a second measurement step, and measurement data in each step is acquired. The synthesis step is a step of generating synthetic data based on each measurement data.

### <Measurement step>

The light projection optical system 10 irradiates a measurement region of the substrate 100 with a laser beam. The light reception optical system 20 measures scattered light generated by the laser beam with which the measurement region is irradiated.

In the present embodiment, the measurement region is defined in the substrate 100. The measurement region is defined by an irradiation region (spot) of the laser beam and/or a light blocking region of the slit 23. The measurement region on the substrate 100 is scanned by driving the stage 30 to measure scattered light on the entire surface of the substrate 100.

As one aspect, the measurement region can be defined to have an arbitrary size and shape by deforming the spot shape of the irradiation light. Furthermore, as one aspect, the measurement region can be defined to have an arbitrary size and shape by limiting a range for receiving the scattered light using the slit 23.

In the measurement step of the present embodiment, for each measurement region on the substrate surface, the intensity of each scattered light is measured using optical systems located in the first direction and the second direction with reference to the measurement region, and measurement data is obtained. The measurement data includes first measurement data based on the first direction and second measurement data based on the second direction. The measurement data may include the N-th measurement data based on two or more directions (N ≥ 2).

Here, the optical system includes the light projection optical system 10 and/or the light reception optical system 20. The optical system viewed from the measurement region refers to at least one of the light projection optical system 10 and the light reception optical system 20. The first direction and the second direction are different directions in the in-plane direction of the XY plane of the substrate 100. In a case where the measurement step acquires a plurality of pieces of measurement data, it is preferable that the measurement directions have angles that are equally spaced in the in-plane direction. Specifically, in a case where the measurement step acquires two pieces of measurement data, the first direction and the second direction are preferably orthogonal to each other in the in-plane direction.

In a case where the optical system is the light projection optical system 10, in the measurement step, by using the light projection optical systems 10 located in the first direction and the second direction as viewed from the measurement region, the scattered light generated is measured to obtain the first measurement data and the second measurement data. At this time, the direction of the light reception optical system 20 is not limited.

In a case where the optical system is the light reception optical system 20, in the measurement step, by using the light reception optical systems 20 located in the first direction and the second direction as viewed from the measurement region, the intensities of the scattered light are measured to obtain the first measurement data and the second measurement data. At this time, the direction of the light projection optical system 10 is not limited.

The measurement data measured in the measurement step has the intensity of the scattered light and positional information. The positional information is information indicating a position where the intensity of the scattered light is measured, and either the substrate position information of the substrate 100 or the stage position information of the stage 30 can be adopted. Note that in a case where the stage position information is adopted, processing for converting the stage position information into the substrate position information is performed.

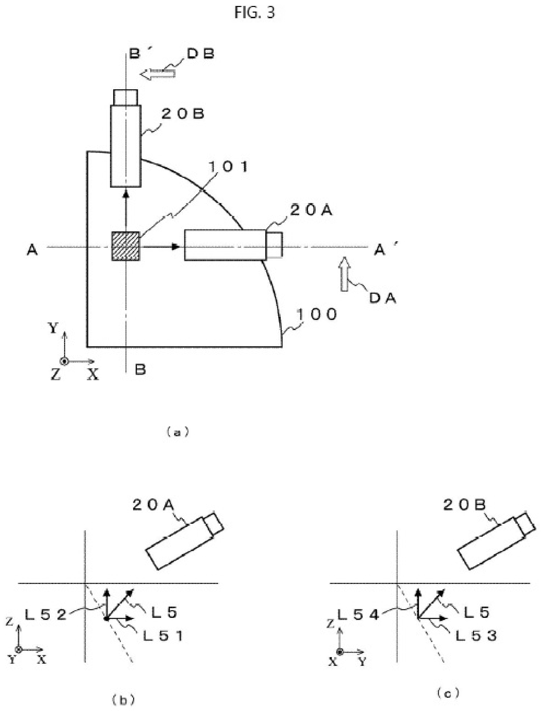

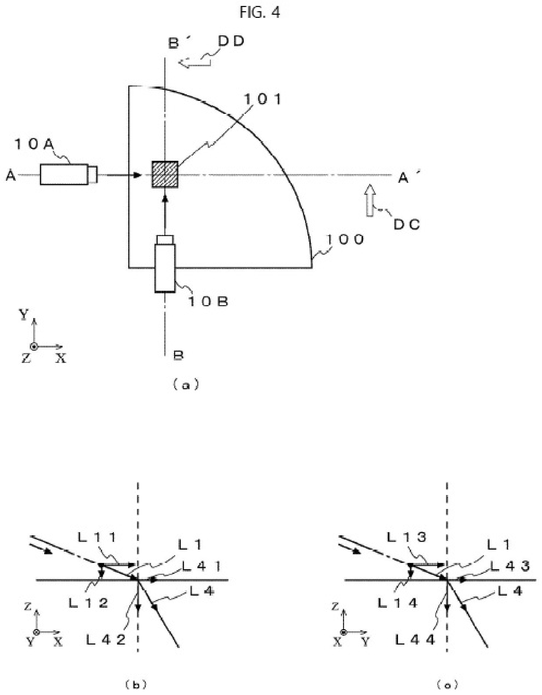

With reference to Figs. 3 and 4 as an example, spatial coordinates are defined with reference to the substrate 100, and the measurement region will be described. In the examples of Figs. 3 and 4, the in-plane direction of the substrate 100 is represented by the XY coordinates, and the height direction (depth direction) is represented by the Z coordinate. The measurement direction is defined as a direction of the light projection optical system 10 and/or the light reception optical system 20 with respect to the measurement region. In other words, the measurement direction is the direction of the light projection optical system 10 and/or the light reception optical system 20 as viewed from the measurement region. In the present embodiment, the measurement direction includes at least two different directions (the first direction and the second direction), and measurement data based on the two measurement directions is obtained.

Fig. 3(a) is a top view of the substrate 100. The measurement region 101 is represented by substrate position information in XY coordinates with reference to the substrate 100. The intensity of the scattered light on the entire surface of the substrate 100 is measured by scanning the measurement region 101 over the in-plane surface of the substrate 100. In Fig. 3(a), the example in which the measurement region 101 has a square shape is illustrated, but the present invention is not limited thereto. The shape of the measurement region 101 can be adjusted by the condenser lens 14 and the slit 23.

The scattered light in the measurement region 101 is measured in different measurement directions (light reception directions). Fig. 3(a) illustrates a light reception optical system 20A that detects scattered light from the X direction and a light reception optical system 20B that detects scattered light from the Y direction. As described above, in the measurement step, the scattered light in at least two directions is measured in one measurement region 101. Here, the light reception optical systems 20A and 20B may be configured to sequentially measure the scattered light in two directions using the same optical system or to simultaneously measure the scattered light in two directions using the different optical systems.

Here, the angle of the incident light on the measurement region 101 is not limited. The light projection optical system 10 may irradiate the measurement region 101 with the laser beam obliquely, or may irradiate the measurement region 101 with the laser beam from directly above. The light projection optical system 10 preferably has an incident angle at which the transmittance of the laser beam into the substrate 100 increases. In a case where the laser beam is P-polarized, the incident angle is preferably a Brewster's angle. By increasing the transmittance of the laser beam into the substrate 100, it is possible to measure the inspection target located deep beneath the surface of the substrate 100.

Fig. 3(b) illustrates the measurement of the internal scattered light L5 when the AA' cross section of Fig. 3(a) is viewed in the arrow direction DA. The internal scattered light L5 is scattered obliquely and has a horizontal component L51 in the X direction and a vertical component L52 in the Z direction. In Fig. 3(b), the light reception optical system 20 can measure the scattered light depending on the horizontal component in the X direction and the vertical component in the Z direction.

Fig. 3(c) illustrates the measurement of the internal scattered light L5 when the BB' cross section of Fig. 3(a) is viewed in the arrow direction DB. The internal scattered light L5 is scattered obliquely and has a horizontal component L53 in the Y direction and a vertical component L54 in the Z direction. In Fig. 3(c), the light reception optical system 20 can measure the scattered light depending on the horizontal component in the Y direction and the vertical component in the Z direction.

In Figs. 3(b) and 3(c), the internal scattered light has been described as an example, but similarly, the scattered light depending on the horizontal components in the XY directions can be measured for the surface scattered light.

In a case where the inspection target has anisotropy in the XY directions on the substrate 100, a difference occurs in the measurement data in the two directions described above. In a case where the inspection target is an elongated scratch or defect, since the inspection target has in-plane anisotropy, the inspection target appears as a difference in measurement data in two directions. Furthermore, in a case where the inspection target is a fine defect or strain, the inspection target is distributed with in-plane anisotropy, and thus, appears as a difference in measurement data in two directions. Furthermore, in a case where the inspection target is strain, since birefringence occurs in the in-plane direction, the birefringence appears as a difference in measurement data in the two directions. For example, in a case of being formed as an elongated scratch or defect with respect to the X direction, it is understood that the intensity of the scattered light in the X direction is smaller than the intensity of the scattered light in the Y direction.

In reality, the inspection target has in-plane anisotropy due to the direction and distribution of scratches or defects, birefringence, and the like. Therefore, in order to reduce the influence of anisotropy for the inspection target having anisotropy, it can be said that it is preferable to use a comprehensive evaluation method with reference to measurement data from a plurality of directions.

Fig. 4(a) is a top view of the substrate 100, and the measurement region 101 is defined on the substrate 100 similarly to Fig. 3. In Fig. 4(a), the scattered light in the measurement region 101 is generated by the laser beam from different measurement directions (irradiation directions). In Fig. 3(a), a light projection optical system 10A that emits a laser beam from the X direction and a light projection optical system 10B that emits a laser beam from the Y direction are illustrated. In the measurement step of Fig. 4, scattered light generated by the irradiation of the laser beams from at least two directions is measured in one measurement region 101. Here, the light projection optical systems 10A and 10B may be configured to sequentially measure the scattered light in two directions using the same optical system or to simultaneously measure the scattered light in two directions using the different optical systems.

Here, the arrangement of the light reception optical system 20 for measuring the scattered light in the measurement region 101 is not particularly limited as long as the light projection optical system 10 and the light reception optical system 20 are on substantially the same straight line when viewed from above. The light reception optical system 20 may measure the scattered light from the measurement region 101 obliquely upward, or may measure the scattered light from the measurement region 101 directly upward. In the present embodiment, the light reception optical system 20 is disposed with the objective lens 21 facing the measurement region 101 above the substrate 100 on the opposite side of the light projection optical system 10 with the measurement region 101 interposed therebetween. The angle of the light reception optical system 20 is appropriately adjusted in accordance with the incident angle of the light projection optical system 10.

Fig. 4(b) illustrates the measurement using the incident light when the AA' cross section of Fig. 4(a) is viewed in the arrow direction DC. In Fig. 4, the incident light L1 is obliquely incident and has a horizontal component L11 in the X direction and a vertical component L12 in the Z direction. When the incident light L1 is obliquely incident on the substrate 100, the transmitted light L4 obliquely propagates inside the substrate 100. Therefore, the transmitted light L4 has a horizontal component L41 in the X direction and a vertical component L42 in the Z direction similarly to the incident light. In Fig. 4(b), the scattered light depending on the horizontal component in the X direction and the vertical component in the Z direction can be generated.

Fig. 4(c) illustrates the measurement using the incident light when the BB' cross section of Fig. 4(a) is viewed in the arrow direction DD. In Fig. 4(c), the incident light L1 is obliquely incident and has a horizontal component L13 in the Y direction and a vertical component L14 in the Z direction. When the incident light L1 is obliquely incident on the substrate 100, the transmitted light L4 obliquely propagates inside the substrate 100, and has a horizontal component L43 in the X direction and a vertical component L44 in the Z direction similarly to the incident light. In Fig. 4(c), the scattered light depending on the horizontal component in the X direction and the vertical component in the Z direction can be generated.

As described above, as illustrated in Figs. 3 and 4, in the measurement step, measurement data depending on the horizontal components in at least two or more directions in the measurement region 101 can be obtained.

Note that the above-described measurement step has been described by using the measurement directions in two directions as an example, but is not limited to two directions. For example, the measurement direction can be multiple directions such as three directions, four directions, and five directions. In the measurement directions in the multiple directions, it is preferable to set the measurement directions at equal intervals.

### <First example>

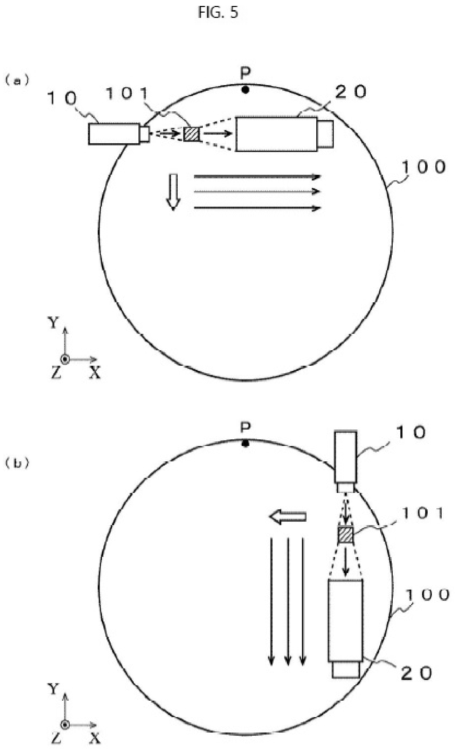

Fig. 5 is a schematic explanatory diagram of the measurement step. In Fig. 5, the evaluation device 1 measures the intensity of scattered light by scanning the measurement region 101 over the entire surface of the substrate 100. The scanning of the measurement region 101 is implemented by moving the stage 30 or moving the housing 40 that supports the light projection optical system 10 and the light reception optical system 20.

In Fig. 5(a), the substrate 100 sets the reference point P as a reference position of the substrate position information. In Fig. 5(a), the light projection optical system 10 and the light reception optical system 20 are disposed to measure the scattered light depending on the horizontal component in the X direction. At least one of the light projection optical system 10 or the light reception optical system 20 is only required to be disposed to measure the scattered light depending on the horizontal component in the X direction.

In Fig. 5(a), the measurement region 101 is scanned with the laser beam by moving in the X direction of the substrate 100 as a movement direction. When the scanning in the X direction is completed in the range from the left end to the right end of the substrate 100, the measurement region 101 moves a distance of a predetermined feed width in the feed direction (Y direction). After the movement in the feed direction, the measurement region 101 is scanned again in the X direction in the range from the left end to the right end of the substrate 100. The entire surface of the substrate 100 can be measured by the scanning based on the movement in the X direction and the feed movement in the Y direction.

In Fig. 5(b), the reference point P indicates the same position as the reference point P in Fig. 5(a). In Fig. 5(b), the light projection optical system 10 and the light reception optical system 20 are disposed to measure the scattered light depending on the horizontal component in the Y direction. At least one of the light projection optical system 10 or the light reception optical system 20 is only required to be disposed to measure the scattered light depending on the horizontal component in the Y direction.

In Fig. 5(b), the measurement region 101 is scanned with the laser beam by moving in the Y direction of the substrate 100 as a movement direction. When the scanning in the Y direction is completed in the range from the upper end to the lower end of the substrate 100, the measurement region 101 moves a distance of a predetermined feed width in the feed direction (X direction). After the movement in the feed direction, the measurement region 101 is scanned again in the Y direction in the range from the upper end to the lower end of the substrate 100. The measurement of the entire surface of the substrate 100 is completed by the scanning based on the movement in the Y direction and the feed movement in the X direction.

### <Second example>

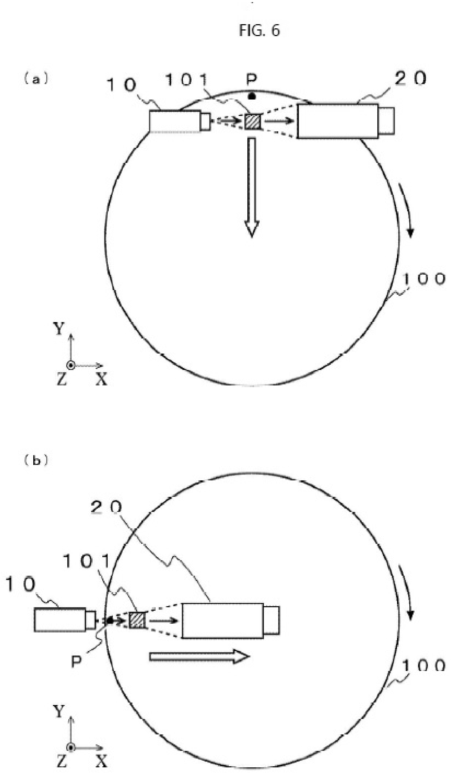

Fig. 6 is a schematic explanatory diagram of the measurement step. In Fig. 6, the evaluation device 1 measures the intensity of scattered light by scanning the measurement region 101 over the entire surface of the substrate 100. The scanning of the measurement region 101 is implemented by the rotation and planar movement of the stage 30, or the rotation of the stage 30 and the planar movement of the housing 40.

In Fig. 6(a), the measurement region 101 is scanned by rotating the substrate 100 in the rotation direction. When scanning by one full rotation of the substrate 100 is completed, the measurement region 101 moves a distance of a predetermined feed width with respect to the feed direction (Y direction). Note that the measurement region 101 may be seamlessly scanned by moving with respect to the feed direction while rotating the substrate 100 one full rotation. The feed direction is a direction from the outer periphery of the substrate 100 toward the center point or the opposite direction. In Fig. 6(a), the start position of the feed direction is the reference point P, and the end position is the center point. The start position and the end position may be reversed. The reference point P is not particularly limited as long as it is on the outer periphery of the substrate 100. After the movement in the feed direction, the measurement region 101 is scanned by rotating the substrate 100 one full rotation again. The entire surface of the substrate 100 can be measured by the scanning resulting from these rotations and the feed movement. In Fig. 6(a), the light projection optical system 10 and the light reception optical system 20 are disposed to measure the scattered light depending on the tangential direction of a concentric circle of the substrate 100.

In Fig. 6(b), the measurement region 101 is scanned by rotating the substrate 100 in the rotation direction. When scanning by one full rotation of the substrate 100 is completed, the measurement region 101 moves by a distance of a predetermined feed width with respect to the feed direction (X direction). Note that similarly to Fig. 6(a), the measurement region 101 may be scanned by moving the distance of the feed width with respect to the feed direction while rotating the substrate 100 one full rotation. Note that the feed widths in the X direction and the Y direction are the same distance. In Fig. 6(b), the start position of the feed direction is the reference point P similar to that of Fig. 6(a), and the end position is the center point. The start position and the end position may be reversed. Note that the start position may be any point on the outer periphery different from the reference point P. In the measurement of Fig. 6(b), the start position is aligned with the reference point P by starting the measurement in a state in which the substrate is rotated by 90 degrees or 270 degrees from the start of the measurement of Fig. 6(a). After moving the distance of the feed width in the feed direction, the measurement region 101 is scanned by rotating the substrate 100 one full rotation again. The entire surface of the substrate 100 can be measured by the scanning resulting from these rotations and the feed movement. In Fig. 6(b), the light projection optical system 10 and the light reception optical system 20 are disposed to measure the scattered light depending on the normal direction of the concentric circle of the substrate 100.

By the measurement steps of Figs. 6(a) and 6(b), the scattered light depending on horizontal components in two orthogonal directions, namely the tangential direction and the normal direction of the concentric circle of the substrate 100 is measured. Note that the measurement region 101 is not limited to measurement of scattered light orthogonal to the tangential direction and the normal direction. The measurement region 101 is only required to be in an orientation in which the movement direction with respect to the substrate 100 is orthogonal, and thus the scattered light depending on the horizontal components in two orthogonal directions can be measured.

Figs. 6(a) and 6(b) illustrate an example in which the optical systems measure the orthogonal scattered light beams in the measurement region 101 having the same substrate position information, by rotating the substrate 100 by 270 degrees or 90 degrees, with the X directions being fixed as the measurement directions. On the other hand, by rotating the optical system through 90 degrees or 270 degrees such that the X direction and the Y direction become measurement directions, respectively, the orthogonal scattered light in the measurement region 101 having the same substrate position information may be measured.

### <Third example>

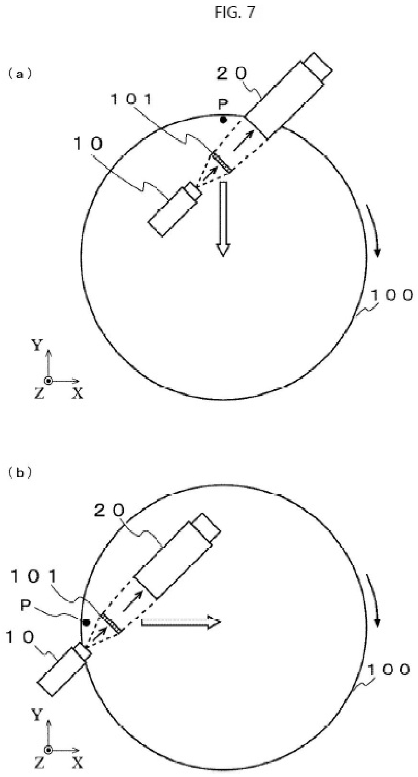

Fig. 7 is a schematic explanatory diagram of the measurement step. In Fig. 7, the measurement region 101 has a rectangular shape or a linear shape. Since the measurement region 101 has a width with respect to the scanning direction, the measurement range can be expanded, and the measurement time can be shortened. In Fig. 7, similarly to the second example, the measurement region 101 is scanned by the rotation and planar movement of the stage 30 or the rotation of the stage 30 and the planar movement of the housing 40. In the third example, the longitudinal direction of the measurement region 101 is inclined with respect to the scanning direction (rotation direction). The inclination angle is preferably 45 degrees with respect to the scanning direction.

In Fig. 7(a), the longitudinal direction of the measurement region 101 is inclined by 45 degrees with respect to the scanning direction. A scanning region A moves in the feed direction (Y direction) from the reference point P, which is the outer periphery of the substrate 100, toward the center point while rotating the substrate 100, and thus the intensity of the scattered light on the entire surface of the substrate 100 is measured.

In Fig. 7(b), the measurement region 101 moves in the feed direction (X direction) from the reference point P of Fig. 7(a) toward the center point while rotating the substrate 100, and thus the intensity of the scattered light on the entire surface of the substrate 100 is measured.

In Figs. 7(a) and 7(b), similarly to the second example, an example is illustrated in which the direction of the optical system is fixed, and the substrate 100 is rotated by 270 degrees or 90 degrees to measure the orthogonal scattered light in the measurement region 101 having the same substrate position information. However, an aspect can be adopted in which the optical system side is rotated by 270 degrees or 90 degrees to measure the orthogonal scattered light in the measurement region 101 having the same substrate position information.

The measurement by the rotational scanning according to the second example and the third example has advantages over the measurement according to the first example in that the measurement time is short, the resonance of the stage 30 is suppressed, the followability of the spot to the strain of the substrate 100 is improved, and the like.

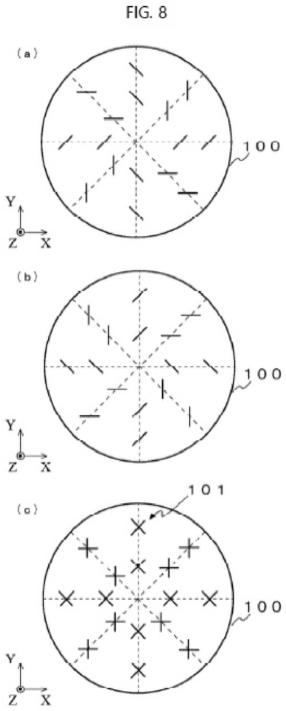

Figs. 8(a) and 8(b) illustrate the orientation of the inspection target measured as strong scattered light through each of the measurement steps of Figs. 7(a) and 7(b). The dotted line portion represents the scanning path of the measurement region 101 through the feed movement. The solid line portion indicates the orientation in which strong scattering occurs on the scanning path.

In Figs. 8(a) and 8(b), the orientations of strong scattering are inclined by 45 degrees with respect to the inclination angle of the measurement region 101. When the orientations of the strong scattering in Figs. 8(a) and 8(b) are compared, the orientations of the strong scattering are reversed and orthogonal to each other due to the start position of the feed direction being shifted by 90 degrees in the substrate 100.

Fig. 8(c) illustrates a result of superimposing Figs. 8(a) and 8(b). In Fig. 8(c), when a certain measurement region 101 is focused, it can be seen that the orientations of the strong scattering are orthogonal to each other. As described above, in the measurement step, the scattered light is measured in a state in which the orientations of the strong scattering are different over the entire surface of the substrate 100, and thus the measurement can be performed at high speed without missing the inspection target present on the substrate 100.

In the measurement step, as described in the first to third examples, by scanning the surface of the substrate 100 with the laser beam, the scattered light is measured in each of a plurality of measurement regions 101 of the substrate 100, and measurement data on the entire surface of the substrate 100 can be obtained based on the plurality of measurement regions 101.

In the measurement step, two measurement directions (the first direction and the second direction) are set with respect to the scanning direction of the laser beam. In the first example, the measurement direction in the X direction with respect to the scanning direction in the X direction and the measurement direction in the Y direction with respect to the scanning direction in the Y direction are set. In the second example, the scanning direction corresponds to rotation, and the measurement direction corresponding to a tangential direction of a concentric circle by rotation and the measurement direction corresponding to a normal direction of the concentric circle by rotation are set. Note that, in the first example and the second example, an example in which the scanning direction and the measurement direction are the same direction has been described, but the inclination of the measurement direction with respect to the scanning direction is not excluded.

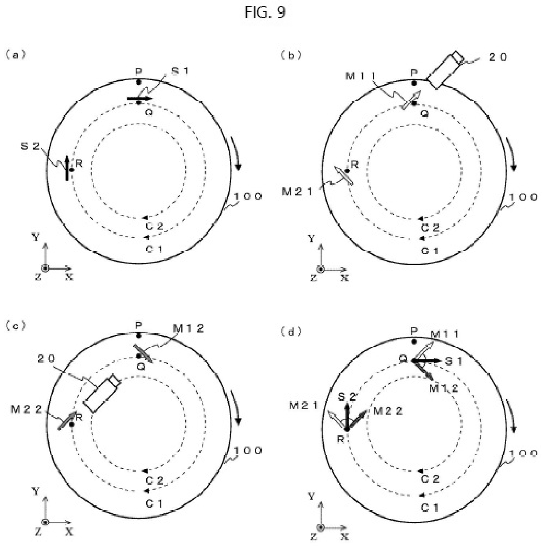

Fig. 9 is an explanatory diagram of a measurement direction set with respect to a scanning direction by rotation. In Fig. 9, by rotating the substrate 100 in the in-plane direction, the laser beam is emitted onto the rotational trajectory C1 of the substrate 100 to perform scanning. Note that the rotational trajectory C has a plurality of trajectories with different radii. Furthermore, by being rotated, the substrate 100 may follow a spiral rotational trajectory with a gradually changing radius. In Fig. 9, the measurement of points Q and R on the rotational trajectory C1 will be described with a focus.

Fig. 9(a) is an explanatory diagram of the scanning direction of the substrate 100. The laser beam is scanned in the scanning direction S1, which is the X direction, at the point Q, and scanned in the scanning direction S2, which is the Y direction, at the point R.

Fig. 9(b) is an explanatory diagram of the measurement direction using the optical system (in the illustrated example, the light reception optical system 20) in the first direction. The scattered light is measured at the point Q in measurement direction M11 and at the point R in measurement direction M21. Note that the same applies to the measurement direction using the light projection optical system 10.

Fig. 9(c) is an explanatory diagram of the measurement direction using the optical system (in the illustrated example, the light reception optical system 20) in the second direction. The scattered light is measured at the point Q in measurement direction M12 and at the point R in measurement direction M22. Note that the same applies to the measurement direction using the light projection optical system 10.

In Figs. 9(b) and 9(c), the position of the optical system is fixed, and the points Q and R on the substrate 100 are measured by rotating the substrate 100.

Fig. 9(d) is an explanatory diagram of the measurement direction with respect to the scanning direction. At the point Q, the scattered light is measured in the first measurement direction M11 and the second measurement direction M12 with respect to the scanning direction S1. At the point R, the scattered light is measured in the first measurement direction M21 and the second measurement direction M22 with respect to the scanning direction S2. Here, the first measurement directions M11 and M21 with respect to the scanning directions S1 and S2 are respectively the same direction, and the second measurement directions M12 and M22 with respect to the scanning directions S1 and S2 are respectively the same direction.

Furthermore, in Fig. 9(d), the in-plane direction of the first measurement direction may be set at a first angle with respect to the rotational trajectory, and the in-plane direction of the second measurement direction may be set at a second angle with respect to the rotational trajectory. The first angle and the second angle are angles with respect to the tangent of the rotational trajectory. In a preferred form of the present embodiment, the first angle is 45 degrees with respect to the tangent of the rotational trajectory and the second angle is -45 degrees with respect to the tangent of the rotational trajectory. That is, the measurement direction is inclined by 45 degrees with respect to the scanning direction.

As described above, by setting the first measurement direction and the second measurement direction with respect to the scanning direction, the scattered light is measured in each of a plurality of measurement regions 101 of the substrate 100 in the same measurement direction, and appropriate measurement data of the entire surface of the substrate 100 can be obtained.

The measurement step in two directions in Figs. 3 to 9 includes a first measurement step of measuring in a first direction and a second measurement step of measuring in a second direction. In the present embodiment, after the first measurement step is performed, the second measurement step is performed. By measuring with the same optical system, it is possible to suppress a difference in measurement data generated based on an individual difference in output intensity of the laser output unit 11, an individual difference in light reception sensitivity of the light reception sensor 24, and the like. In particular, the scattered light caused by strain of the subsurface damaged layer is extremely weak, and a slight individual difference in the light reception sensitivity affects the measurement data.

In the first measurement step and the second measurement step, the position of the optical system is fixed, and the substrate 100 is rotated and moved in a plane to scan the laser beam. In the first measurement step, the scattered light in the measurement region is measured using an optical system whose position is fixed, and in the second measurement step, the scattered light is measured while the orientation of the measurement region is changed.

In a case where the first measurement step and the second measurement step are performed twice using one optical system, the measurement data in the first measurement step and the second measurement step has the intensity of the scattered light and the stage position information. The measurement data in the first measurement step has the intensity of the scattered light measured in the first direction with respect to a certain measurement region and the first stage position information. The measurement data in the second measurement step has the intensity of the scattered light measured in the second direction with respect to the certain measurement region and the second stage position information.

In the first measurement step and the second measurement step, the intensities of the scattered light measured in the same measurement region of the substrate 100 are synthesized in a synthesis step to be described later. The intensities of the scattered light in the same measurement region to be synthesized are identified as having the same substrate position information. In the first measurement step and the second measurement step, since the position of the optical system is fixed, it is necessary to change the first direction and the second direction with respect to the measurement region by rotating the substrate 100 in each step. Thus, when the same substrate position information in the first measurement step and the second measurement step is referred to, the first stage position information and the second stage position information indicate different stage positions.

The position alignment processing is performed on the first stage position information and the second stage position information based on the substrate position information of the reference point P of the substrate 100. The position alignment processing refers to processing of aligning the first stage position information and the second stage position information, which indicate different stage positions, to be the same substrate position information. A plurality of reference points may be set on the substrate 100. In the first measurement step and the second measurement step, pieces of stage position information to be aligned with the substrate position information as the reference point are acquired.

In the present embodiment, position alignment processing is performed in at least one of the measurement step or the synthesis step. The timing of the position alignment processing is not limited as long as the synthetic data of the intensities of the scattered light in the two directions is obtained after the stage position information of two pieces of measurement data is aligned as the same substrate position information.

In the first measurement step, first measurement data including the first stage position information and the intensity of the scattered light in the first direction is acquired. The control unit 50 rotates and/or moves the stage 30 in a plane to acquire the first measurement data on the entire surface of the substrate 100. In the first measurement step, substrate position information to be at least one or more reference points used for the position alignment processing and first stage position information to be aligned with the substrate position information are acquired.

In the second measurement step, second measurement data including the second stage position information and the intensity of the scattered light in the second direction is acquired. The control unit 50 rotates and/or moves the stage 30 in a plane to acquire the second measurement data on the entire surface of the substrate 100. In the second measurement step, substrate position information to be at least one or more reference points used for the position alignment processing and second stage position information to be aligned with the substrate position information are acquired.

The first measurement step and the second measurement step may be performed simultaneously by using two optical systems. As described above, even in a case where there is an individual difference between the two optical systems, the measurement in the two directions can be performed simultaneously by correcting the difference in the measurement data resulting from the individual difference therebetween. Thus, the measurement step can be further speeded up.

In a case where the first measurement step and the second measurement step are performed simultaneously by two optical systems, the measurement data in the first measurement step and the second measurement step have the intensity of the scattered light and the stage position information or the substrate position information. In the simultaneous measurement, two pieces of the measurement data have the intensity of scattered light for the same measurement region and the same substrate position information. Alternatively, in the simultaneous measurement, the positional relationship between the pieces of substrate position information included in the two pieces of measurement data is defined in advance, and the pieces of measurement data having the same substrate positional information are associated with each other based on the defined positional relationship.

### <Control for position alignment processing>

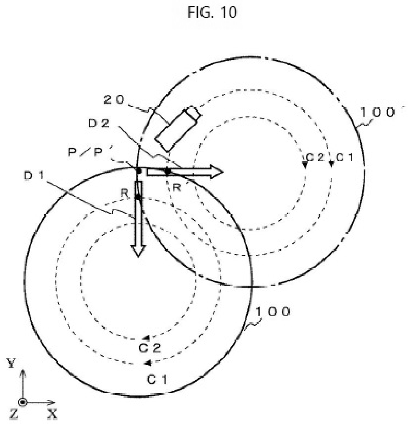

Fig. 10 is an explanatory diagram regarding control for position alignment processing in the first measurement step and the second measurement step. Here, an example of the control in the measurement step through rotational scanning will be described. In Fig. 10, the substrate 100 measured in the first measurement step is indicated by a solid line, and the substrate 100' measured in the second measurement step is indicated by a one-dot chain line. The substrate 100' shows a state in which the substrate 100 is rotated by 270 degrees (3π/2). The point P of the substrate 100 and the point P' of the substrate 100' indicate the same substrate position.

In Fig. 10, the position of the optical system (light reception optical system 20) is fixed at a position where the points P and P' are measured. The point P is a reference point, and is used for position alignment processing of the stage position information and the substrate position information. The reference point is set in advance so as to be aligned with, for example, the end or the center of the substrate 100.

In the first measurement step, the control unit 50 controls the stage 30 so as to obtain the substrate position information of the reference point P as the start position. Here, first stage position information W1 and substrate position information S1 of the reference point P are associated with each other for position alignment processing. The control unit 50 moves the stage 30 in a plane in a feed direction D1 (Y direction) while rotating the stage 30 (substrate 100), and acquires the first measurement data. The first measurement data is time-series data of a scattered light intensity I1(t) and first stage position information W1(t) as a measurement time t.

In the second measurement step, the control unit 50 rotates and moves the stage 30 in a plane such that a reference point P/P' as the start position overlaps. In Fig. 10, the stage 30 is rotated by 270 degrees, and further moved in a plane by a distance corresponding to a radius r in the X direction and the Y direction. Here, second stage position information W2 and substrate position information S1 of the reference point P/P' are associated with each other for position alignment processing. The control unit 50 moves the stage 30 in a plane in a feed direction D2 (X direction) while rotating the stage 30 (substrate 100), and acquires the second measurement data. The second measurement data is time-series data of a scattered light intensity I2(t) and second stage position information W2(t) as a measurement time t.

In the case of rotational scanning, the start positions in the first measurement step and the second measurement step are set as the reference point P/P', such that the rotational trajectories match each other. Therefore, when the first stage position information W1 and the second stage position information W2 of the start position are aligned as the substrate position information of the reference point P, the substrate position information of the subsequent time-series data also matches. The time-series data of the first measurement data and the second measurement data subjected to the position alignment processing has substrate position information S(t), a scattered light intensity I1(t), and a scattered light intensity I2(t).

Note that the first measurement step and the second measurement step are not limited to the configuration in which the start positions match with each other. In the first measurement step and the second measurement step, when the substrate position information of the reference point P and the first stage position information and second stage position information corresponding thereto are obtained, the substrate position information of the first measurement data and the substrate position information of the second measurement data can be aligned.

Furthermore, similarly, also in the planar movement scanning, when the substrate position information as the reference point and the corresponding first stage position information and second stage position information are obtained, the substrate position information of the first measurement data and the substrate position information of the second measurement data can be aligned.

Although an example in which the reference point is provided at the end is described in the present specification, the rotational center of the stage 30 (substrate 100) may be used as the reference point. At this time, in the first measurement step, the substrate 100 is moved in the first movement direction (for example, in the X direction,) while being rotated to obtain first measurement data. Furthermore, in the second measurement step, the substrate 100 is moved in the second movement direction (for example, in the Y direction,) while being rotated to obtain second measurement data. Each of the first movement direction and the second movement direction is a feed direction and corresponds to the radial direction of the substrate 100. The start positions of the first measurement step and the second measurement step are the rotational centers set as the reference point, and the entire surface is measured by performing feed movement toward the outside of the substrate 100. In this case, the end position of the measurement is the outer end of the substrate 100.

By setting the feed widths in the first measurement step and the second measurement step to the same distance, the feed positions r of the first measurement data and the second measurement data in the radial direction match each other. Furthermore, in the second measurement step, the measurement is started in a state in which the substrate 100 is rotated by 90 degrees or 270 degrees from the start of the measurement in the first measurement step, and thus the end positions of the measurement on the substrate 100 can match with each other. More preferably, the substrate position information of the first measurement data and the substrate position information of the second measurement data are aligned by matching the start position and the end position of the measurement on the substrate 100.

### <Measurement data>

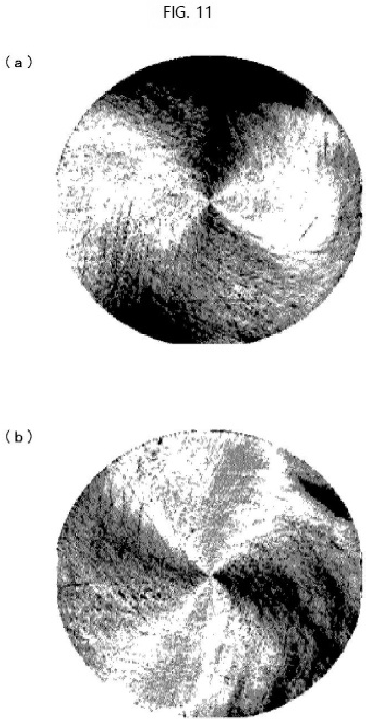

Fig. 11 illustrates measurement data in the measurement step of the third example. Fig. 11(a) is measurement data in the first measurement step, and is an image reflecting the scattered light intensity in the orientation of strong scattering in Fig. 8(a). Fig. 11(b) is measurement data in the second measurement step, and is an image reflecting the scattered light intensity in the orientation of strong scattering in Fig. 8(b). The measurement data of Fig. 11 is displayed in different colors corresponding to intensities, such as red, yellow, and green in descending order of scattered light intensity. In the region with the high scattered light intensity, it can be grasped that there are many inspection targets.

When Figs. 11(a) and 11(b) are compared with each other, each scattered light intensity appears at a position where the intensity distribution having a butterfly pattern is reversed. It is understood that such a difference in the intensity distribution is caused by the fact that the orientations of strong scattering are orthogonal due to the difference in the measurement direction. Furthermore, it is obvious that it is difficult to grasp all the inspection targets existing on the substrate 100 only by the measurement from one direction.

### <Synthesis step>

The control unit 50 generates synthetic data based on the measurement data obtained in the first direction and the second direction in the measurement region (synthesis step). The control unit 50 generates synthetic data by synthesis processing of averaging the measurement data in the first measurement step and the measurement data in the second measurement step. In the present embodiment, the averaging is performed by dividing the total value of the scattered light intensities in pieces of positional information by two. Note that, for the averaging, calculation methods such as arithmetic mean, geometric mean, and harmonic mean are not limited. Furthermore, the synthesis processing is not limited to averaging as long as it is a calculation method capable of suppressing dependency of scattered light due to measurement data obtained in different measurement directions, and other calculation methods can be adopted.

Note that, in the synthesis step, the positional information of the first measurement data and the positional information of the second measurement data are aligned to generate synthetic data. The control unit 50 acquires the first measurement data including the scattered light intensity I1(t) and the first stage position information W1(t), and the second measurement data including the scattered light intensity I2(t) and the second stage position information W2(t), and generates the position alignment data having the substrate position information S(t), the scattered light intensity I1(t), and the scattered light intensity I2(t). The control unit 50 generates the synthetic data by averaging the scattered light intensities of the records of the position alignment data.

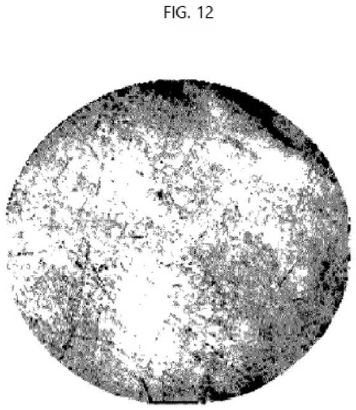

Fig. 12 illustrates synthetic data generated in the synthesis step. Similarly to Fig. 11, the synthetic data is displayed in different colors corresponding to intensities, such as red, yellow, and green in descending order of scattered light intensity. The synthetic data has a value obtained by averaging the intensity values of a plurality of pieces of measurement data. In the synthetic data, the influence of the intensity distribution that appears reversely is suppressed by synthesizing the measurement data obtained in two directions. Therefore, it can be said that the synthetic data is data more accurately representing the intensity distribution of the scattered light on the substrate 100.

The quality and the like of the substrate 100 are evaluated by using the synthetic data as described above. For example, a region with the high scattered light intensity in the synthetic data can be evaluated as a region having a large degree of defects or subsurface damaged layers which are inspection target.

### Reference Signs List

- 1: Evaluation device
- 10: Light projection optical system
- 11: Laser output unit
- 12: Filter
- 13: Wave plate
- 14: Condenser lens
- 20: Light reception optical system
- 21: Objective lens
- 22: Imaging lens
- 23: Slit
- 24: Light reception sensor
- 30: Stage
- 31: Three-axis drive unit
- 32: Rotation drive unit
- 40: Housing
- 50: Control unit
- 51: Stage control unit
- 52: Signal processing unit
- 53: Synthesis processing unit
- 100: Substrate

## Claims

1. A substrate evaluation method using laser light scattering, the method comprising:
a measurement step of measuring scattered light for each measurement region on a substrate surface using optical systems present in a first direction and a second direction with reference to the measurement region to obtain first measurement data and second measurement data; and
a synthesis step of synthesizing the first measurement data and the second measurement data to generate synthetic data.

2. The substrate evaluation method according to claim 1, wherein the first direction and the second direction are different in an in-plane direction of the substrate.

3. The substrate evaluation method according to claim 2, wherein the first direction and the second direction are orthogonal to each other in an in-plane direction.

4. The substrate evaluation method according to claim 1, wherein each of the optical systems includes a light reception optical system that receives scattered light generated on the substrate, and
in the measurement step, the scattered light is measured using the light reception optical systems present in the first direction and the second direction with reference to the measurement region to obtain the first measurement data and the second measurement data.

5. The substrate evaluation method according to claim 1, wherein each of the optical systems includes a light projection optical system that irradiates a surface of the substrate with a laser beam, and
in the measurement step, the scattered light generated using the light projection optical systems present in the first direction and the second direction with reference to the measurement region is measured to obtain the first measurement data and the second measurement data.

6. The substrate evaluation method according to claim 1, wherein the measurement step includes measuring the scattered light in each of a plurality of the measurement regions on the substrate by scanning the substrate surface with a laser beam.

7. The substrate evaluation method according to claim 6, wherein the first direction and the second direction are set with respect to the scanning direction.

8. The substrate evaluation method according to claim 6, wherein the measurement region is set so as to be inclined with respect to the scanning direction.

9. The substrate evaluation method according to claim 1, wherein the measurement step includes measuring the scattered light by irradiating a surface of the substrate with a laser beam while rotating the substrate in an in-plane direction.

10. The substrate evaluation method according to claim 9, wherein in the measurement step, the substrate is rotated in the in-plane direction to irradiate a rotational trajectory of the substrate with the laser beam, and
the in-plane direction of the first direction and the in-plane direction of the second direction are set at a first angle and a second angle with respect to the rotational trajectory.

11. The substrate evaluation method according to claim 1, wherein the measurement step includes a first measurement step and a second measurement step,
in the first measurement step and the second measurement step, the first measurement data and the second measurement data are acquired by measuring the scattered light while changing an orientation of the measurement region with respect to the optical systems whose positions are fixed, and
in the synthesis step, positional information of the first measurement data and positional information of the second measurement data are aligned to generate the synthetic data.

12. The substrate evaluation method according to claim 11, wherein in the first measurement step, the first measurement data is obtained by scanning a laser beam by moving the substrate in a first movement direction while rotating the substrate in an in-plane direction, and
in the second measurement step, the second measurement data is obtained by scanning the laser beam by moving the substrate in a second movement direction different from the first movement direction while rotating the substrate in the in-plane direction.

13. The substrate evaluation method according to claim 12, wherein in the second measurement step, measurement is started in a state in which the substrate is rotated by 90 degrees or 270 degrees from the start of measurement in the first measurement step.

14. The substrate evaluation method according to claim 11, wherein the scattered light is measured using a same optical system in the first measurement step and the second measurement step.

15. The substrate evaluation method according to any one of claims 1 to 14, wherein the measurement region has a linear shape or a rectangular shape.

16. A substrate evaluation device using laser light scattering, the device comprising:
a light projection optical system that irradiates a substrate with a laser beam;
a light reception optical system that measures scattered light;
a stage that includes a three-axis drive unit that moves the substrate in a plane; and
a control unit that controls movement of the stage to a reference position of the substrate, the position being a start position of each of first measurement and second measurement.

17. The substrate evaluation device according to claim 16, wherein the stage further includes a rotation drive unit that rotates the substrate, and
the control unit controls planar movement of the stage in different feed directions in the first measurement and the second measurement using the three-axis drive unit while rotating the stage using the rotation drive unit.

18. The substrate evaluation device according to claim 16 or 17, wherein the control unit aligns positional information of two pieces of measurement data measured by the first measurement and the second measurement, and performs synthesis processing to synthetic data.
